# EUROPÄISCHE PATENTSCHRIFT

(11) **EP 3 391 706 B1**
(45) Veröffentlichungstag und Bekanntmachung des Hinweises auf die Patenterteilung: **27.04.2022**
(21) Anmeldenummer: 16794246.5
(22) Anmeldetag: 03.11.2016
(51) Int. Cl.: H05B 3/86, H05K 1/02, H05K 1/03, H05K 3/22

(54) **VERFAHREN ZUR REPARATUR VON SUBSTRATEN MIT ELEKTRISCH LEITFÄHIGER BESCHICHTUNG**
METHOD FOR REPAIRING SUBSTRATES WITH ELECTRICALLY CONDUCTIVE COATING
PROCEDE DE REPARATION DE SUBSTRATS PAR REVETEMENT ELECTROCONDUCTEUR

(30) Priorität: 17.12.2015 EP 15200674
(43) Veröffentlichungstag der Anmeldung: 24.10.2018
(73) Patentinhaber: SAINT-GOBAIN GLASS FRANCE, 92400 Courbevoie (FR)
(72) Erfinder: SCHULZ, Valentin, 52382 Niederzier (DE); GILLESSEN, Stephan, 52477 Alsdorf (DE)
(74) Vertreter: Gebauer, Dieter Edmund
(86) Internationale Anmeldenummer: PCT/EP2016/076498
(87) Internationale Veröffentlichungsnummer: WO 2017/102168

(56) Entgegenhaltungen:
- EP-A2- 1 052 704
- DE-A1-102004 029 164
- US-A- 3 930 304
- US-A- 4 166 918
- US-A1- 2002 145 434
- US-A1- 2003 229 832
- US-A1- 2008 318 011
- US-A1- 2012 288 968

## Beschreibung

Die Erfindung betrifft ein Verfahren zur Nachbehandlung von Substraten mit elektrisch leitfähiger Beschichtung und dessen Verwendung.

Transparente Substrate mit elektrisch leitfähiger Beschichtung werden bereits in den verschiedensten Anwendungsgebieten eingesetzt, beispielsweise als Windschutzscheibe in Kraftfahrzeugen, als beheizbare Spiegel oder auch als Heizkörper in Wohnräumen. In Kraftfahrzeugen können diese in Form von beheizbaren Windschutzscheiben, Seitenscheiben oder Heckscheiben verwendet werden um die Fahrzeugfenster frei von Eis und Kondenswasser zu halten. Die in einem Substrat vorliegenden Heizelemente sollten für den Betrachter sowohl aus ästhetischen Gründen, als auch unter Sicherheitsaspekten nicht oder kaum sichtbar sein. Das Sichtfeld von Windschutzscheiben darf aufgrund gesetzlicher Vorgaben keine Sichteinschränkungen aufweisen. Drahtförmige heizbare Elemente in Windschutzscheiben entsprechen zwar diesen gesetzlichen Vorgaben, jedoch verursachen die Drähte besonders bei Dunkelheit und Gegenlicht störende Reflexionen. In den letzten Jahren werden besonders im Automobilbereich, aber auch im Baubereich, verstärkt Scheiben mit einer infrarotreflektierenden elektrisch leitfähigen Beschichtung eingesetzt. Derartige Beschichtungen verfügen einerseits über eine gute elektrische Leitfähigkeit, die eine Beheizung der Scheibe ermöglicht und darüber hinaus über infrarotreflektierende Eigenschaften, die eine unerwünschte Erwärmung des Innenraums durch Sonneneinstrahlung vermindern. Diese Schichtsysteme sind somit nicht nur hinsichtlich sicherheitsrelevanter Aspekte, wie einer uneingeschränkten Sicht, sondern auch unter ökologischen Gesichtspunkten, wie einer Reduzierung des Schadstoffausstoßes, und einer Verbesserung des Fahrzeugkomforts von besonderer Bedeutung. Die Beschichtungen umfassen dabei elektrisch leitfähige Schichten, insbesondere auf Silberbasis. Die Beschichtungen sind üblicherweise mit zwei Stromsammelschienen (auch Sammelleiter oder Busbars genannt) elektrisch kontaktiert, zwischen denen ein Strom durch die beheizbare Beschichtung fließt. Diese Art der Beheizung ist beispielsweise in WO 03/024155 A2, US 2007/0082219 A1 und US 2007/0020465 A1 beschrieben, die Schichtsysteme aus mehreren Silberschichten offenbaren, die den Flächenwiderstand der leitfähigen Beschichtung weiter senken.

Verfahren wie beispielsweise magnetfeldgestützte Kathodenzerstäubung zur Abscheidung derartiger Schichtsysteme sind dem Fachmann hinlänglich bekannt. Die Abscheidung der transparenten infrarotreflektierenden elektrisch leitfähigen Beschichtung kann wahlweise auf einer der innenliegenden Seiten der Außenscheibe oder der Innenscheibe erfolgen oder auch auf einer Trägerfolie, die zwischen den Scheiben eingelegt wird. Die direkte Abscheidung der Beschichtung auf einer der Scheibenoberflächen ist unter wirtschaftlichen Gesichtspunkten vor allem bei Produktion großer Stückzahlen vorteilhaft und somit das zur Herstellung von Windschutzscheiben gebräuchliche Verfahren.

Abhängig von der Geometrie des zu beheizenden Substrats kann die elektrisch leitfähige Beschichtung durch Isolationslinien in verschiedene Bereiche geteilt sein um beispielsweise eine möglichst gleichmäßige Beheizung zu erreichen oder einzeln ansteuerbare Heizfelder zu erzeugen. Ferner wird auch ein Randbereich der Beschichtung parallel zur Substratkante elektrisch isoliert um einer Korrosion der Beschichtung durch Feuchtigkeit und Umgebungseinflüsse vorzubeugen.

EP 1626940 B1 offenbart eine heizbare Scheibe mit mehreren Heizbereichen, in denen eine elektrisch leitfähige Beschichtung aufgebracht ist, wobei die elektrisch leitfähige Beschichtung eines Heizbereichs durch Isolationslinien elektrisch von den anderen Heizbereichen isoliert ist. Auf der Beschichtung sind Stromsammelschienen angebracht, die eine Beheizung der Beschichtung durch Anlegen einer elektrischen Spannung ermöglichen. Die einzelnen Heizbereiche fungieren dabei als in Serie geschaltete Widerstandselemente, die sich durch den Spannungsabfall erwärmen.

Ferner ist es aus WO 2014/060203 bekannt mittels entschichteter Bereiche in einer elektrisch leitfähigen Beschichtung gezielt die Transmission von hochfrequenter elektromagnetischer Strahlung zu erhöhen und so den Betrieb von Mobiltelefonen und satellitengestützter Navigation im Fahrzeuginnenraum zu ermöglichen. Gemäß den in WO 2014/060203 offenbarten Ausführungsformen liegen dabei mehrere zueinander konzentrisch angeordnete entschichtete Bereiche (Isolationslinien) vor, innerhalb derer sich Bereiche mit einer elektrisch leitfähigen Beschichtung befinden.

Zur Herstellung derartiger Substrate mit entschichteten Bereichen können nach Abscheidung der elektrisch leitfähigen Beschichtung auf einem Substrat, entschichtete Bereiche, beispielsweise mittels eines Lasers oder durch Ätzen erzeugt werden. Bei diesen nach dem Stand der Technik bekannten Verfahren zur Erzeugung von Isolationslinien können Überreste der leitfähigen Beschichtung oder einzelne leitfähige Partikel im Bereich der Isolationslinien verbleiben, so dass die Isolationslinien nicht durchgehend sind. Dadurch sind die einzelnen Bereiche der elektrisch leitfähigen Beschichtung, die durch Einbringen einer Isolationslinie voneinander getrennt werden sollen, immer noch elektrisch leitend verbunden. Dies führt beispielsweise zu einer inhomogenen Beheizung des Substrats durch lokale Überhitzung einzelner Bereiche (Ausbildung sogenannter "*Hot spots*")*.* Diese Substrate entsprechen nicht den erforderlichen Spezifikationen.

EP 1052704 A1 zeigt eine Serienverschaltung von Solarzellen, bei der Defekte in der photovoltaisch aktiven Schicht durch Anlegen eines Stroms beseitigt werden. US 2012/288968 A1 zeigt einen Halbleiterchip, bei der Kurzschlussbrücken zwischen Leitungen durch Anlegen eines Stroms verbrannt werden. US 2008/318011 A1 zeigt eine Scheibe, bei der Abschnitte einer elektrisch leitfähigen Beschichtung, die von verschiedenen Phasen einer Spannung beaufschlagt sind, durch breite Trennlinien unterteilt sind. DE 10 2004029164 A1 zeigt eine Verbundglasscheibe mit Isolationslinien. US 2003/229832 A1, US 2002/145434 A1 und US 3930304 A zeigen jeweils Verfahren, bei denen zur Beseitigung von Defekten Strom an Elektroden angelegt wird.

Der vorliegenden Erfindung liegt die Aufgabe zugrunde, ein vereinfachtes Verfahren zur Reparatur von Laserschnittmustern auf Substraten mit elektrisch leitfähiger Beschichtung, sowie dessen Verwendung bereitzustellen.

Die Aufgabe der vorliegenden Erfindung wird erfindungsgemäß durch ein Verfahren zur Nachbehandlung eines Substrats mit elektrisch leitfähiger Beschichtung und mindestens einer Isolationslinie im Produktionsprozess gemäß Anspruch 1, sowie dessen Verwendung gemäß Anspruch 9 gelöst. Bevorzugte Ausführungsformen gehen aus den Unteransprüchen hervor.

Das erfindungsgemäße Verfahren zur Nachbehandlung eines Substrats mit einer elektrisch leitfähigen Beschichtung und mindestens einer Isolationslinie im Produktionsprozess, umfasst die folgenden Schritte
a) Bereitstellung eines Substrats,
b) Kontaktieren eines ersten elektrischen Kontakts mit einem ersten Teilbereich und Kontaktieren eines zweiten elektrischen Kontakts mit einem zweiten Teilbereich der elektrisch leitfähigen Beschichtung,
c) Anlegen einer Spannung Uₙ zwischen erstem elektrischen Kontakt und zweitem elektrischen Kontakt,
d) Messen ob ein elektrischer Strom zwischen erstem Teilbereich und zweitem Teilbereich der elektrisch leitfähigen Beschichtung fließt, mittels des am ersten Teilbereich anliegenden ersten elektrischen Kontakts und mittels des am zweiten Teilbereich anliegenden zweiten elektrischen Kontakts,
e) Wiederholen der Schritte c) und d) mit einer Spannung von größer oder gleich Uₙ, sofern in Schritt d) ein Strom zwischen erstem Teilbereich und zweitem Teilbereich gemessen wurde, so lange bis in Schritt d) kein Strom mehr zwischen erstem Teilbereich und zweitem Teilbereich fließt und die elektrisch leitfähige Beschichtung und/oder elektrisch leitfähige Partikel im Bereich des Defekts thermisch zersetzt sind. Dabei kann es sich beispielsweise um eine Oxidationsreaktion handeln.

Bei einem Substrat mit einer elektrisch leitfähigen Beschichtung kann es sich im Sinne der Erfindung um eine Beschichtung handeln, die zur Beheizung des Substrats geeignet ist. Ferner umfasst die Erfindung auch Substrate mit elektrisch leitfähigen Beschichtungen an denen keine Mittel zum Anlegen einer Spannung, wie beispielsweise Sammelleiter, angebracht sind. Demnach sind auch infrarotreflektierende Beschichtungen, die lediglich die Funktion haben eine Erwärmung des hinter der Scheibe liegenden Raumes zu verhindern umfasst. Dem Fachmann sind infrarotreflektierende Beschichtungen bekannt, die ebenfalls elektrisch leitfähig sind, an denen jedoch nicht zwangsläufig Mittel zum Anlegen einer elektrischen Spannung vorliegen.

Das Substrat in Schritt a) weist dabei mindestens eine elektrisch leitfähige Beschichtung auf mindestens einer Oberfläche des Substrats auf, wobei mindestens eine Isolationslinie in die elektrisch leitfähige Beschichtung eingebracht ist, die mindestens einen ersten Teilbereich und einen zweiten Teilbereich der Beschichtung voneinander abgrenzt. Die Isolationslinie weist dabei optional mindestens einen Defekt auf, an dessen Position der lokale Schichtwiderstand geringer ist als der Schichtwiderstand der Isolationslinie außerhalb des Defekts. Die Isolationslinie hat die Aufgabe den ersten Teilbereich der Beschichtung vom zweiten Teilbereich der Beschichtung elektrisch zu isolieren. Im Bereich der Isolationslinie ist die elektrisch leitfähige Beschichtung entfernt, wobei die Isolationslinie mindestens einen Defekt aufweist, in dessen Bereich die elektrisch leitfähige Beschichtung nur ungenügend entfernt ist oder ein elektrisch leitfähiger Partikel verblieben ist. Im Bereich des Defekts ist der Schichtwiderstand somit wesentlich geringer als im Bereich der Isolationslinie, wodurch im Bereich des Defekts elektrischer Strom geleitet wird und die beiden Teilbereiche der elektrisch leitfähigen Beschichtung elektrisch miteinander kontaktiert sind. Sofern ein Defekt vorhanden ist, ist der flächenmäßige Anteil des Defekts an der Gesamtfläche der Isolationslinie kleiner als 10 %.

Gemäß dem erfindungsgemäßen Verfahren werden alle Substrate im Produktionsprozess nachbehandelt und dabei eventuell vorhandene Defekte der Isolationslinie repariert. In dieser Hinsicht ist es als besonders vorteilhaft anzusehen, dass defekte Substrate nicht zunächst identifiziert und ausgesondert werden müssen, sondern alle Substrate diesen Prozess durchlaufen. Dabei wird an allen heizbaren Substraten eine Spannung Uₙ zwischen erstem Teilbereich und zweitem Teilbereich der Beschichtung angelegt. Sofern kein Defekt der Isolationslinie vorhanden ist, sind der erste Teilbereich und der zweite Teilbereich elektrisch voneinander isoliert und es fließt kein Strom zwischen diesen Bereichen. Die angelegte Spannung ruft in diesem Fall keinerlei strukturelle Veränderungen am Substrat hervor. Wenn ein Defekt im Bereich der Isolationslinie vorhanden ist, so sind erster Teilbereich und zweiter Teilbereich über diesen Defekt elektrisch miteinander kontaktiert und es fließt über den Defekt ein Strom zwischen diesen Teilbereichen. Der Defekt ist im Vergleich zur Isolationslinie flächenmäßig klein (kleiner als 10 % der Gesamtfläche der Isolationslinie), so dass die Stromdichte im Bereich des Defekts groß ist. Dadurch findet im Bereich des Defekts eine sehr starke Erwärmung statt, die schließlich zu einem Verbrennen der leitfähigen Beschichtung bzw. leitfähigen Partikel im Bereich des Defekts führt. Dieser Bereich mit thermisch zersetzter Beschichtung verläuft dabei von einem freien Ende der Isolationslinie, durch den Bereich des Defekts zum anderen freien Ende der Isolationslinie. Als freie Enden der Isolationslinie werden in diesem Sinne die dem Defekt unmittelbar benachbarten Abschnitte der Isolationslinie bezeichnet. Der im Bereich des vormaligen Defekts vorliegende Bereich mit thermisch zersetzter Beschichtung wirkt elektrisch isolierend und trennt den ersten Teilbereich der Beschichtung vom zweiten Teilbereich der Beschichtung elektrisch. Dadurch wird der Defekt behoben und das Substrat mit repariertem Defekt zeigt ein Heizverhalten, das identisch ist mit Substraten ohne Defekt.

Somit werden der im Produktionsprozess auftretende Ausschuss und die damit einhergehenden Produktionskosten entscheidend gesenkt.

Im nächsten Schritt des Verfahrens (Schritt d) wird mittels der elektrischen Kontakte, die am ersten bzw. zweiten Teilbereich der Beschichtung angelegt sind, gemessen ob ein Strom zwischen diesen Bereichen fließt. Sofern kein Strom fließt wurde der Defekt erfolgreich repariert oder es war kein Defekt vorhanden. In beiden Fällen ist das Verfahren beendet und das Substrat wird dem weiteren Produktionsprozess zugeführt.

In Schritt e) des erfindungsgemäßen Verfahrens werden die Schritte c) und d) mit einer Spannung, die mindestens der Spannung Uₙ aus dem vorhergehenden Schritt c) entspricht, ein- oder mehrfach wiederholt, sofern im vorhergehenden Schritt d) ein Strom zwischen beiden Teilbereichen der Beschichtung gemessen wurde und somit noch immer ein Defekt der Isolationslinie vorliegt. Durch Wiederholung von Schritt c) des Verfahrensverlängert sich die Gesamtzeit, in der der Defekt der angelegten Spannung ausgesetzt ist. Danach wird erneut mittels Schritt d) kontrolliert ob die Reparatur erfolgreich war und die Schritte c) und d) gegebenenfalls erneut wiederholt.

Im Bereich der Isolationslinie liegt der Widerstand beispielsweise in der Größenordnung des Widerstands des Substratmaterials. Die möglicherweise im Bereich der intakten Isolationslinie verbleibenden Spuren der elektrisch leitfähigen Beschichtung sind vernachlässigbar. Der Widerstand im Bereich der Isolationslinie liegt besonders bevorzugt bei größer als 10⁶ Ω.

Im Bereich des Defekts ist der Widerstand wesentlich niedriger als im Bereich der Isolationslinie. In der praktischen Umsetzung des Verfahrens spielt eine geringe Abweichung dabei keine Rolle. Der Fachmann wird mittels der Messung in Schritt d) des erfindungsgemäßen Verfahrens herausfinden ob ein Defekt vorliegt. Wenn ein Defekt als solcher identifizierbar ist, ist der elektrische Widerstand im Bereich des Defekts nicht wesentlich höher als der Schichtwiderstand der elektrisch leitfähigen Beschichtung, wodurch der elektrische Strom über den Defekt fließt. Der Widerstand im Bereich des Defekts liegt besonders bevorzugt bei kleiner als 10⁶ Ω. In der Praxis zeigen sich meist sehr geringe Widerstände im Bereich des Defekts, die in der Größenordnung mehrerer Ohm liegen, als Beispiel seien hier 6 Ω genannt.

Sofern in Schritt d) des Verfahrens noch ein Stromfluss zwischen beiden Teilbereichen festgestellt wird, so können die Schritte c) und d) auch mit einer Spannung Uₙ₊₁ wiederholt werden, wobei gilt Uₙ₊₁ > Uₙ. Danach wird erneut mittels Schritt d) kontrolliert ob die Reparatur erfolgreich war und die Schritte c) und d) gegebenenfalls erneut mit einer weiter erhöhten Spannung wiederholt. Dieser iterative Prozess ist vor allem bei einer erstmaligen Anwendung des Verfahrens sinnvoll. Die benötigte Spannung ist abhängig von der Geometrie des Substrats, der Positionierung der elektrischen Kontakte und der Beschaffenheit der elektrisch leitfähigen Beschichtung, lässt sich jedoch durch die beschriebene iterative Vorgehensweise auf einfache Weise empirisch ermitteln. Sobald ein entsprechender Erfahrungswert für die benötigte Spannung bei bestimmten Substraten vorliegt, wird dieser bei den nachfolgenden Substraten gleicher Beschaffenheit bereits bei der ersten Ausführung von Schritt c) des erfindungsgemäßen Verfahrens angewandt. Somit ist in der Regel nur eine einmalige Ausführung der Schritte c) und d) erforderlich, sobald ein Arbeitsbereich der Spannung ermittelt wurde.

Wie bereits diskutiert sollte der flächenmäßige Anteil des Defekts an der Gesamtfläche der Isolationslinie kleiner als 10 % betragen. Bevorzugt liegt dieser Anteil bei kleiner als 5 %, besonders bevorzugt kleiner als 3 %. Die Defektgröße beträgt bevorzugt kleiner 1000 µm, besonders bevorzugt kleiner 700 µm, insbesondere kleiner 500 µm. Typische Defektgrößen liegen beispielsweise bei ungefähr 100 µm. Diese Angaben beziehen sich auf die jeweilige Größe eines Defektes, es können auch mehrere Defekte innerhalb dieser Größenordnungen vorliegen. In der Praxis konnten auch Scheiben mit 5 bzw. 7 vorsätzlich erzeugten Defekten in einer Größenordnung innerhalb der genannten Bereiche mittels des erfindungsgemäßen Verfahrens repariert werden.

Besonders bei mehreren Defekten kann es sein, dass die Schritte c) und d) mehrfach wiederholt werden müssen um eine vollständige Reparatur der Isolationslinie zu bewerkstelligen. Dabei muss nicht zwangsläufig die angelegte Spannung erhöht werden, es ist in der Regel bereits ausreichend Schritt c) mit der gleichen Spannung zu wiederholen. So kann es beispielsweise vorkommen, dass bei der ersten Ausführung des Schritts c) nur ein Defekt repariert wurde. Danach nimmt die Leistungsdichte bei angelegter Spannung im Bereich des zweiten Defekts zu. Wenn jedoch zu diesem Zeitpunkt Schritt c) bereits abgebrochen wird, so wird der zweite Defekt nicht repariert. In diesem Fall ist es ausreichend Schritt c) mit der vorhergehend verwendeten Spannung zu wiederholen.

Besonders bei Substraten mit neuen Designs, an denen das erfindungsgemäße Verfahren noch nicht angewandt wurde, wird der Fachmann zunächst mit einer vergleichsweise geringen Spannung beginnen und diese bei Bedarf steigern. In einer beispielhaften Ausführung des Verfahrens an einer Windschutzscheibe mit zwei Heizfeldern wird bei der erstmaligen Ausführung des Schritts c) eine Spannung Uₙ von 5 V angelegt und diese, sofern erforderlich, iterativ erhöht. Die genauen Werte der angelegten Spannung spielen dabei für die Ausführung des Verfahrens keine Rolle. Ein Wert von 5 V kann bei kleinen Substraten mit geringem Abstand der angelegten elektrischen Kontakte und einer Beschichtung mit hoher Leitfähigkeit bereits ausreichend sein. Somit ist es sinnvoll einen Wert dieser Größenordnung als Startwert zu wählen. In der Praxis hat sich gezeigt, dass je nach Substratgröße, Beschichtung und Positionierung der elektrischen Kontakte meist Werte zwischen 10 V und 30 V geeignet sind.

Allgemein werden die Spannungen Uₙ bzw. Uₙ₊₁ bevorzugt so gewählt, dass sie bei kleiner als 200 V, besonders bevorzugt kleiner als 100 V, insbesondere zwischen 3 V und 50 V liegen. Bei sehr kleinen Substraten mit einer Beschichtung hoher Leitfähigkeit und einem geringen Abstand des ersten elektrischen Kontakts und des zweiten elektrischen Kontakts können bereits 0,1 V ausreichen. Im erfindungsgemäßen Verfahren lässt sich der geeignete Spannungsbereich bei Bedarf iterativ ermitteln.

In einer besonders bevorzugten Ausführungsform des Verfahrens ist die, an ein in Einbaulage beheiztes Substrat, angelegte Spannung kleiner oder gleich der im regulären Betrieb des Substrats genutzten Spannung. Wird das Substrat als Bestandteil einer beheizten Windschutzscheibe in Fahrzeugen mit 14 V Bordspannung verwendet, so würde demnach die maximal angelegte Spannung 14 V betragen. So kann sichergestellt werden, dass keine Schäden an der Beschichtung oder anderen Bauteilen durch Anlegen einer unsachgemäß hohen Spannung auftreten. In der Praxis hat sich jedoch gezeigt, dass auch höhere Spannungen möglich sind ohne Schäden hervorzurufen. Auch bei einem Substrat, dessen Beschichtung für eine Bordspannung von 14 V ausgelegt ist, hat sich in der Praxis gezeigt, dass Spannungen von bis zu 30 V und darüber hinaus unproblematisch sind. Bei Substraten, die in Kraftfahrzeugen mit einer Bordspannung von 42 V oder 48 V betrieben werden sollen, kann die Spannung dementsprechend höher gewählt werden. Die Begrenzung auf die jeweilige Betriebsspannung stellt lediglich eine Vorsichtsmaßnahme dar.

Die in Schritt c) des erfindungsgemäßen Verfahrens anzulegende Spannung hängt neben den genannten Parametern auch von der Zeitspanne ab, über die die Spannung angelegt wird. Je kürzer die Zeitspanne, desto höher wird tendenziell die angelegte Spannung gewählt. Dabei sollte die Zeitspanne einerseits nicht zu lang sein um einen zügigen Fortgang des Prozesses zu ermöglichen, andererseits wird aus sicherheitsrelevanten Gründen bevorzugt bei nicht zu hohen Spannungen gearbeitet. Üblicherweise wird die Spannung Uₙ bzw. Uₙ₊₁ für 1 Sekunde bis 10 Sekunden, bevorzugt 2 Sekunden bis 6 Sekunden, angelegt.

Beispielhaft seien folgende Kombinationen von Zeitspanne und angelegter Spannung zur Ausführung von Verfahrensschritt c) genannt: 14 V über 5 Sekunden, 20 V über 5 Sekunden oder 20 V über 3 Sekunden. Diese Parameter wurden anhand von Windschutzscheiben als Substrate erprobt, es hat sich jedoch gezeigt, dass diese auch weitestgehend auf andere Substratgrößen anwendbar sind. Besonders bei kleineren Substratgrößen würde auch eine niedrigere Spannung bzw. Zeitspanne ausreichen, jedoch ist es vorteilhaft den Prozess nicht abändern zu müssen.

Der erste elektrische Kontakt und der zweite elektrische Kontakt sind dem Fachmann geläufige Mittel zur elektrischen Kontaktierung und zeichnen sich durch ihre gute Leitfähigkeit aus. Die Kontakte können beispielsweise über eine metallische Beschichtung, vorzugsweise eine Edelmetall-Beschichtung, beispielsweise eine Vergoldung, verfügen um eine möglichst verlustfreie Spannungsübertragung zu ermöglichen. Die Kontakte können beispielsweise nadelförmig ausgeführt sein. Sofern die Produktionsanlage bereits über Messelektroden zur Widerstandsmessung und Qualitätskontrolle der elektrisch leitfähigen Beschichtung verfügt, können diese als erster elektrischer Kontakt und als zweiter elektrischer Kontakt im erfindungsgemäßen Verfahren genutzt werden. Eine zusätzliche finanzielle Investition sowie größere Modifikationen des Produktionsprozesses sind somit zur Anwendung des erfindungsgemäßen Verfahrens nicht erforderlich.

Bevorzugt werden der erste elektrische Kontakt unmittelbar auf die elektrisch leitfähige Beschichtung im ersten Teilbereich und der zweite elektrische Kontakt unmittelbar auf die elektrisch leitfähige Beschichtung im zweiten Teilbereich aufgesetzt. Es ist demnach in diesem Schritt des Verfahrens nicht notwendig Sammelleiter und/oder Anschlusselemente anzubringen, sondern die Kontaktierung kann unabhängig davon erfolgen. Je nach Anordnung des ersten Teilbereichs, des zweiten Teilbereichs der Beschichtung und der Sammelleiter kann es auch sinnvoll sein den ersten elektrischen Kontakt und den zweiten elektrischen Kontakt unmittelbar auf der elektrisch leitfähigen Beschichtung aufzusetzen, obwohl bereits Sammelleiter angebracht wurden. Dies ist insbesondere der Fall, wenn mindestens einer der beiden Teilbereiche, zwischen denen die Isolationslinie verläuft, nicht zur Beheizung der Scheibe vorgesehen ist. In diesem Fall werden auch im späteren Verlauf des Verfahrens keine Sammelleiter in diesem unbeheizten Teilbereich vorgesehen und der entsprechende elektrische Kontakt muss unmittelbar auf die elektrisch leitfähige Beschichtung aufgesetzt werden. Ein Beispiel dafür ist ein umlaufender Randbereich der Beschichtung, der häufig mittels einer Isolationslinie von der restlichen Beschichtung getrennt wird um eine Korrosion durch am Rand eintretende Feuchtigkeit zu vermeiden. Diese umlaufende Isolationslinie könnte ebenfalls mittels des erfindungsgemäßen Verfahrens repariert werden, wobei der umlaufende Randbereich einen nicht zur Beheizung der Scheibe vorgesehenen Teilbereich darstellt. Dem Fachmann sind weitere Beispiele bekannt, in denen ein Teilbereich der elektrisch leitfähigen Beschichtung abgetrennt wird, der nicht der Beheizung des Substrats dient.

Das erfindungsgemäße Verfahren kann somit auch genutzt werden um Isolationslinien zwischen zwei Teilbereichen der elektrisch leitfähigen Beschichtung zu bearbeiten, die im späteren Produkt nicht beheizt werden. Ein Beispiel dafür sind die bereits genannten nach dem Stand der Technik bekannten infrarotreflektierenden Beschichtungen, die ebenfalls elektrisch leitfähig und beheizbar sind, aber nicht zwangsläufig zur Beheizung genutzt werden.

Des Weiteren können Substratkonfigurationen auftreten, in denen die Sammelleiter erst nach Schritt e) des erfindungsgemäßen Verfahrens aufgebracht werden dürfen. Dies ist beispielsweise der Fall, wenn ein Sammelleiter eine elektrisch leitende Verbindung zwischen den Teilbereichen der Beschichtung herstellt, die bei Anwendung des erfindungsgemäßen Verfahrens beteiligt sind. Nach Anlegen einer Spannung über den ersten elektrischen Kontakt und den zweiten elektrischen Kontakt würde der Stromfluss über den entsprechenden Sammelleiter verlaufen und nicht, wie gewünscht, über den Defekt der Isolationslinie. In diesem Fall sollte zunächst das erfindungsgemäße Verfahren ausgeführt werden und erst nach Schritt e) der entsprechende Sammelleiter angebracht werden.

Sofern die Sammelleiter keinen elektrischen Kontakt zwischen erstem Teilbereich und zweitem Teilbereich der Beschichtung herstellen, können der oder die Sammelleiter auch vor Schritt b) im ersten Teilbereich und/oder zweiten Teilbereich elektrisch leitend auf der elektrisch leitfähigen Beschichtung kontaktiert werden. In diesem Fall können der erste elektrische Kontakt und der zweite elektrische Kontakt in Schritt b) an den Sammelleitern kontaktiert werden. Alternativ ist auch hier eine unmittelbare elektrische Kontaktierung der Beschichtung im ersten Teilbereich und im zweiten Teilbereich möglich.

Die Sammelleiter sind dafür vorgesehene, mit einer externen Spannungsquelle verbunden zu werden, so dass ein Strom zwischen den Sammelleitern durch die leitfähige Beschichtung fließt. Die Beschichtung fungiert so als Heizschicht und beheizt die Verbundscheibe infolge ihres elektrischen Widerstandes, beispielsweise um die Scheibe zu enteisen oder von Feuchtigkeitsbeschlag zu befreien.

Das Anbringen der Sammelleiter kann insbesondere durch Auflegen, Aufdrucken, Löten oder Kleben erfolgen.

In einer bevorzugten Ausführungsform sind die Sammelleiter als aufgedruckte und eingebrannte leitfähige Struktur ausgebildet. Die aufgedruckten Sammelleiter enthalten zumindest ein Metall, bevorzugt Silber. Die elektrische Leitfähigkeit wird bevorzugt über Metallpartikel, enthalten im Sammelleiter, besonders bevorzugt über Silberpartikel, realisiert. Die Metallpartikel können sich in einer organischen und / oder anorganischen Matrix wie Pasten oder Tinten befinden, bevorzugt als gebrannte Siebdruckpaste mit Glasfritten. Die Schichtdicke der aufgedruckten Stromsammelschienen beträgt bevorzugt von 5 µm bis 40 µm, besonders bevorzugt von 8 µm bis 20 µm und ganz besonders bevorzugt von 10 µm bis 15 µm. Aufgedruckte Sammelleiter mit diesen Dicken sind technisch einfach zu realisieren und weisen eine vorteilhafte Stromtragfähigkeit auf.

Alternativ sind die Sammelleiter als Streifen einer elektrisch leitfähigen Folie ausgebildet. Die Stromsammelschienen enthalten dann beispielsweise zumindest Aluminium, Kupfer, verzinntes Kupfer, Gold, Silber, Zink, Wolfram und/oder Zinn oder Legierungen davon. Der Streifen hat bevorzugt eine Dicke von 10 µm bis 500 µm, besonders bevorzugt von 30 µm bis 300 µm. Sammelleiter aus elektrisch leitfähigen Folien mit diesen Dicken sind technisch einfach zu realisieren und weisen eine vorteilhafte Stromtragfähigkeit auf. Der Streifen kann mit der elektrisch leitfähigen Beschichtung beispielsweise über eine Lotmasse, über einen elektrisch leitfähigen Kleber oder ein elektrisch leitfähiges Klebeband oder durch direktes Auflegen elektrisch leitend verbunden sein. Zur Verbesserung der leitenden Verbindung kann zwischen leitfähiger Beschichtung und Sammelleiter beispielsweise eine silberhaltige Paste angeordnet werden.

Die elektrisch leitfähige Beschichtung wird vor Schritt a) auf das Substrat aufgebracht. Geeignete Verfahren dazu sind dem Fachmann hinreichend bekannt. In der Regel werden dabei Methoden der physikalischen Gasphasenabscheidung (PVD) genutzt. Besonders bevorzugt wird die Methode des Kathodenzerstäubens, insbesondere magnetfeldunterstützten Kathodenzerstäubens (Magnetron-Sputtern) angewandt. Dadurch können elektrisch leitfähige Beschichtungen in hoher elektrischer und optischer Qualität schnell, kostengünstig und bei Bedarf auch großflächig erzeugt werden.

Die Isolationslinie wird erzeugt, indem die elektrisch leitfähige Beschichtung im Bereich der Isolationslinie entfernt wird. Dazu sind dem Fachmann die verschiedensten Verfahren, wie beispielsweise Ätzen, mechanische abrasive Verfahren oder Laserverfahren bekannt. Laserverfahren stellen dabei die nach dem Stand der Technik gängigsten Verfahren dar. Die Laserbearbeitung erfolgt mit einer Wellenlänge von 300 nm bis 1300 nm. Die eingesetzte Wellenlänge hängt dabei von der Art der Beschichtung ab. Als Laserquelle werden bevorzugt gepulste Festkörperlaser eingesetzt. Die bei der Laserbearbeitung abgetragenen Partikel werden über eine Partikelabsaugung entfernt. Es hat sich als sinnvoll erwiesen den Laserstrahl durch das Substrat hindurch auf die elektrisch leitfähige Beschichtung zu fokussieren und die Partikelabsaugung auf der gegenüberliegenden Seite des Substrats zu positionieren. Dadurch ist die Partikelabsaugung in unmittelbarer Nachbarschaft zu den beim Laserprozess entstehenden Partikeln angeordnet, so dass eine möglichst effektive Absaugung besteht.

Die Isolationslinie hat bevorzugt eine Breite von 1 µm bis 10 mm, besonders bevorzugt 10 µm bis 2 mm, ganz besonders bevorzugt 50 µm bis 500 µm, insbesondere 50 µm bis 200 µm, beispielsweise 100 µm oder 90 µm oder 80 µm. Bereits diese Breiten der Isolationslinie sind ausreichend um eine elektrische Isolation der Teilbereiche der elektrisch leitfähigen Beschichtung voneinander zu bewirken.

In einer bevorzugten Ausführungsform des Verfahrens wird das Substrat nach Schritt e) unter Zwischenlage einer thermoplastischen Zwischenschicht mit einem zweiten Substrat zu einer Verbundscheibe laminiert.

Die Herstellung des Verbundglases durch Lamination erfolgt mit üblichen, dem Fachmann an sich bekannten Methoden, beispielsweise Autoklavverfahren, Vakuumsackverfahren, Vakuumringverfahren, Kalanderverfahren, Vakuumlaminatoren oder Kombinationen davon. Die Verbindung von Außenscheibe und Innenscheibe dabei erfolgt üblicherweise unter Einwirkung von Hitze, Vakuum und / oder Druck.

Geeignete thermoplastische Zwischenschichten sind dem Fachmann hinreichend bekannt. In der Regel umfasst die thermoplastische Zwischenschicht mindestens eine Laminierfolie aus Polyvinylbutyral (PVB), Ethylenvinylacetat (EVA) oder Polyurethan (PU), bevorzugt Polyvinylbutyral (PVB). Die Dicke der Laminierfolien beträgt bevorzugt von 0,2 mm bis 2 mm, besonders bevorzugt von 0,3 mm bis 1 mm, beispielsweise 0,38 mm oder 0,76 mm. Die thermoplastische Zwischenschicht kann auch aus mehreren Laminierfolien und optional einer zwischen zwei Laminierfolien liegenden zusätzlichen Folie bestehen. Diese zusätzliche Folie dient der Einbringung weiterer Funktionalitäten. So sind beispielsweise thermoplastische Zwischenschichten aus mehreren polymeren Folien bekannt, die akustisch dämpfende Eigenschaften aufweisen.

Das Verbundglas kann auch mit einer Zusatzfunktion versehen werden, indem die thermoplastische Zwischenschicht funktionelle Einlagerungen aufweist, beispielsweise Einlagerungen mit IR-absorbierenden, UV-absorbierenden, und/oder farbgebenden Eigenschaften. Die Einlagerungen sind beispielsweise organische oder anorganische Ionen, Verbindungen, Aggregate, Moleküle, Kristalle, Pigmente oder Farbstoffe.

In einer alternativen Ausführungsform des erfindungsgemäßen Verfahrens wird das Substrat vor Schritt a) mit einem zweiten Substrat und einer thermoplastischen Zwischenschicht zu einem Verbundglas laminiert. Erst danach werden die Schritte a) bis e) des erfindungsgemäßen Verfahrens durchgeführt. Eine solche Vorgehensweise ist auch im Sinne der Erfindung. Allerdings wurde in Versuchen festgestellt, dass in der Umgebung des reparierten Defekts der Isolationslinie eine für den Betrachter sichtbare Trübung im Verbundglas auftritt. Diese ist meist als gräulich-schwarze Einfärbung erkennbar. Da derartige Beeinträchtigungen unerwünscht sind, erfolgt ein Laminationsverfahren in der Regel nach Schritt e) des erfindungsgemäßen Verfahrens.

Gezeigt, aber nicht Teil der Erfindung ist ein mit dem erfindungsgemäßen Verfahren nachbehandeltes Substrat, wobei das Substrat mindestens eine Isolationslinie mit mindestens einem reparierten Defekt umfasst. Bei einer entsprechenden optischen Vergrößerung der Isolationslinie im Bereich des reparierten Defekts ist dieser eindeutig als solcher zu erkennen und ersichtlich, dass eine Herstellung mittels des erfindungsgemäßen Verfahrens erfolgte. Im Bereich des reparierten Defekts weist die elektrisch leitfähige Beschichtung einen Bereich mit thermisch zersetzter Beschichtung auf, der zwischen den beiden, dem Defekt benachbarten, Enden der Isolationslinie verläuft. Im Bereich des reparierten Defekts wird die Isolationslinie durch diesen Bereich der thermisch zersetzten Beschichtung vervollständigt, so dass in Summe eine vollständige elektrische Trennung der Teilbereiche durch die Isolationslinie und den genannten Bereich besteht.

In einer bevorzugten Ausführungsform ist das Substrat mit einem zweiten Substrat unter Zwischenlage einer thermoplastischen Zwischenschicht zu einer Verbundscheibe laminiert.

Das Substrat und/oder das zweite Substrat enthalten bevorzugt Glas, besonders bevorzugt Flachglas, Floatglas, Quarzglas, Borosilikatglas, Kalk-Natron-Glas oder Kunststoffe, insbesondere Polyethylen, Polyethylenterephthalat, Polypropylen, Polycarbonat, Polymethylmethacrylat, Polystyrol, Polyamid, Polyester, Polyvinylchlorid und/oder Gemische oder Copolymere davon.

Die Dicke der Substrate kann breit variieren und so hervorragend den Erfordernissen im Einzelfall angepasst werden. Vorzugsweise betragen die Dicken des Substrats und des zweiten Substrats von 0,5 mm bis 10 mm und bevorzugt von 1 mm bis 5 mm, ganz besonders bevorzugt von 1,4 mm bis 3 mm.

Das Substrat, das zweite Substrat und/oder die thermoplastische Zwischenschicht können klar und farblos, aber auch getönt, getrübt oder gefärbt sein. Das Substrat und/oder das zweite Substrat können aus nicht vorgespanntem, teilvorgespanntem oder vorgespanntem Glas bestehen.

In einer alternativen Ausführungsform ist das Substrat eine Trägerfolie, auf die die elektrisch leitfähige Beschichtung aufgetragen und in die die Isolationslinie eingebracht wird. Das erfindungsgemäße Verfahren ändert sich dabei nicht und ist auch in diesem Fall wie beschrieben anzuwenden. Im Anschluss an das erfindungsgemäße Verfahren kann die Trägerfolie mit elektrisch leitfähiger Beschichtung in den verschiedensten Verglasungen verwendet werden, beispielsweise als Zwischenlage in einer thermoplastischen Zwischenschicht einer Verbundglasscheibe oder auch als Flächenelektrode in schaltbaren Verglasungen, beispielsweise im Bereich der Gebäudeverglasung oder Automobilverglasung.

Gemäß der alternativen Ausführungsform des Substrats als Trägerfolie enthält die Trägerfolie bevorzugt zumindest Polyethylenterephthalat (PET), Polyethylen (PE) oder Gemische oder Copolymere oder Derivate davon. Das ist besonders vorteilhaft für die Handhabung die Stabilität und die optischen Eigenschaften der Trägerfolie. Die Trägerfolie weist bevorzugt eine Dicke von 5 µm bis 500 µm, besonders bevorzugt von 10 µm bis 200 µm und ganz besonders bevorzugt von 12 µm bis 75 µm. Trägerschichten mit diesen Dicken lassen sich vorteilhaft in Form von flexiblen und gleichzeitig stabilen Folien bereitstellen, dies sich gut handhaben lassen.

In dieser alternativen Ausführungsform ist das Substrat (die Trägerfolie) ebenfalls mit einem zweiten Substrat unter Zwischenlage einer thermoplastischen Zwischenschicht laminiert. Dabei sind auch auf der gegenüberliegenden Seite des Substrats eine thermoplastische Zwischenschicht und ein weiteres (drittes) Substrat angebracht. Das dritte Substrat entspricht in seiner Zusammensetzung den möglichen Zusammensetzungen des zweiten Substrats, jedoch können beide in einer Verbundscheibe auch unterschiedliche Zusammensetzungen haben. Eine mögliche Schichtabfolge der alternativen Ausführungsform lautet: zweites Substrat - thermoplastische Zwischenschicht - Substrat (Trägerfolie) mit elektrisch leitfähiger Beschichtung und reparierter Isolationslinie -thermoplastische Zwischenschicht - drittes Substrat.

Die elektrisch leitfähige Beschichtung enthält unabhängig von der Ausführungsform des Substrats bevorzugt Silber und/oder ein elektrisch leitfähiges Oxid, besonders bevorzugt Silber, Titandioxid, Aluminiumnitrid und/oder Zinkoxid, wobei ganz besonders bevorzugt Silber eingesetzt wird.

Die elektrisch leitfähige Beschichtung ist bevorzugt transparent. Darunter wird im Sinne der Erfindung eine Beschichtung verstanden, die im Spektralbereich von 500 nm bis 700 nm eine Lichttransmission von größer 70% aufweist. Es handelt sich also um eine Beschichtung, die dafür vorgesehen und geeignet ist, im Wesentlichen flächendeckend auf der Scheibe aufgebracht zu werden, wobei die Durchsicht erhalten bleibt.

Einige der im Automobilbereich bekannten elektrisch leitfähigen Beschichtungen verfügen gleichzeitig über infrarotreflektierende Eigenschaften, die eine Erwärmung des hinter der Scheibe liegenden Raums vermindern. Die elektrisch leitfähige Beschichtung ist in einer bevorzugten Ausführungsform infrarotreflektierend. Die elektrisch leitfähige Beschichtung weist zumindest eine elektrisch leitfähige Schicht auf. Die Beschichtung kann zusätzlich dielektrische Schichten aufweisen, die beispielsweise zur Regulierung des Schichtwiderstands, zum Korrosionsschutz oder zur Verminderung der Reflexion dienen. Die leitfähige Schicht enthält bevorzugt Silber oder ein elektrisch leitfähiges Oxid (transparent conductive oxide, TCO) wie Indium-Zinn-Oxid (indium tin oxide, ITO). Die leitfähige Schicht weist bevorzugt eine Dicke von 10 nm bis 200 nm auf. Zur Verbesserung der Leitfähigkeit bei gleichzeitig hoher Transparenz kann die Beschichtung mehrere elektrisch leitfähige Schichten aufweisen, welche durch zumindest eine dielektrische Schicht voneinander getrennt sind. Die leitfähige Beschichtung kann beispielsweise zwei, drei oder vier elektrisch leitfähige Schichten enthalten. Typische dielektrische Schichten enthalten Oxide oder Nitride, beispielsweise Siliziumnitrid, Siliziumoxid, Aluminiumnitrid, Aluminiumoxid, Zinkoxid oder Titanoxid. Derartige elektrisch leitfähige Beschichtungen sind nicht auf eine Anwendung in heizbaren Ausführungsformen der Verbundscheibe beschränkt. Auch in Scheiben ohne Heizfunktion werden die genannten infrarotreflektierenden elektrisch leitfähigen Beschichtungen eingesetzt, wobei die Beschichtung in diesem Fall allein die Aufgabe eines Sonnenschutzes erfüllt.

In einer besonders bevorzugten Ausgestaltung weist die elektrisch leitfähige Beschichtung mindestens eine elektrisch leitfähige Schicht auf, welche Silber enthält, bevorzugt mindestens 99% Silber. Die Schichtdicke der elektrisch leitfähigen Schicht beträgt bevorzugt von 5 nm bis 50 nm, besonders bevorzugt von 10 nm bis 30 nm. Die Beschichtung weist bevorzugt zwei oder drei dieser leitfähigen Schichten auf, welche durch zumindest eine dielektrische Schicht voneinander getrennt sind. Solche Beschichtungen sind besonders vorteilhaft im Hinblick zum einen auf die Transparenz der Scheibe und zum anderen auf ihre Leitfähigkeit.

Der Schichtwiderstand der elektrisch leitfähigen Beschichtung beträgt bevorzugt von 0,5 Ohm/Quadrat bis 7,5 Ohm/Quadrat. Damit werden bei üblicherweise im Fahrzeugbereich verwendeten Spannungen vorteilhafte Heizleistungen erreicht, wobei geringe Schichtwiderstände bei gleicher angelegter Spannung zu höheren Heizleistungen führen.

Beispiele für Schichtaufbauten, die gleichermaßen über eine hohe elektrische Leitfähigkeit und eine infrarotreflektierende Wirkung verfügen, sind dem Fachmann aus WO 2013/104439 und WO 2013/104438 bekannt.

Bevorzugt ist das Substrat mit einem zweiten Substrat und einer thermoplastischen Zwischenschicht zu einer Windschutzscheibe laminiert, wobei die Isolationslinie entlang der Scheibenmitte senkrecht zur Dachkante der Windschutzscheibe verläuft. Die Dachkante der Windschutzscheibe ist dabei die Kante, die nach Einbau der Verglasung im Fahrzeug entlang des Dachhimmels verläuft, während die der Dachkante gegenüberliegende Kante als Motorkante bezeichnet wird. Die seitlichen Kanten der Windschutzscheibe sind im Einbauzustand den als A-Säulen bezeichneten Karosserieabschnitten benachbart. Die Isolationslinie teilt in dieser Ausführungsform die elektrisch leitfähige Beschichtung in einen ersten Teilbereich zwischen einer seitlichen Kante (benachbart zu einer A-Säule) und der Isolationslinie und einen zweiten Teilbereich zwischen der anderen seitlichen Kante (benachbart zu der anderen A-Säule) und der Isolationslinie. Eine derartige Aufteilung der Teilbereiche wird beispielsweise verwendet um zwei unabhängig voneinander schaltbare Heizfelder zu erzeugen. Ein anderes Beispiel wäre eine Reihenschaltung dieser beiden Heizfelder, wobei ein Sammelleiter die beiden Teilbereiche über die Isolationslinie hinweg elektrisch leitend verbindet. Das erfindungsgemäße Verfahren hat sich als sehr effektiv zur Bearbeitung derartiger Substrate mit einer Isolationslinie entlang der Scheibenmitte senkrecht zur Dachkante der Windschutzscheibe erwiesen.

Bevorzugt stellt das Substrat die Innenscheibe der Windschutzscheibe dar. Dabei verfügt das Substrat über eine Innenseite, auf der sich die elektrisch leitfähige Beschichtung befindet, und eine Außenseite, die in Einbaulage zum Fahrzeuginnenraum gerichtet ist. Das zweite Substrat wird dabei als Außenscheibe der Windschutzscheibe verwendet, wobei die Innenseite des zweiten Substrats dem Substrat zugewandt ist und die Außenseite des zweiten Substrats in Richtung der äußeren Fahrzeugumgebung orientiert ist. Zwischen der Innenseite der Innenscheibe und der Innenseite der Außenscheibe befindet sich die thermoplastische Zwischenschicht, die die Substrate miteinander verbindet.

Die Erfindung betrifft ferner die Verwendung des erfindungsgemäßen Verfahrens zur Reparatur von Isolationslinien in leitfähigen Beschichtungen in Automobilverglasung, bevorzugt Windschutzscheiben, Seitenscheiben oder Heckscheiben, besonders bevorzugt Windschutzscheiben.

Im Folgenden wird die Erfindung anhand von Zeichnungen und Ausführungsbeispielen näher erläutert. Die Zeichnungen sind rein schematische Darstellungen und nicht maßstabsgetreu. Die Zeichnungen schränken die Erfindung in keiner Weise ein.

Es zeigen:
- Figuren 1a und 1b: ein Substrat mit einer elektrisch leitfähigen Beschichtung, die von einer Isolationslinie in zwei Teilbereiche aufgeteilt wird, wobei die Isolationslinie einen Defekt aufweist,
- Figur 2: das Substrat gemäß Figuren 1a und 1b, wobei jeweils ein Kontakt am ersten Teilbereich und am zweiten Teilbereich angelegt ist, zwischen denen ein Strom fließt,
- Figuren 3a und 3b: das Substrat gemäß Figuren 1a und 1b nach Ausführung des erfindungsgemäßen Verfahrens laminiert als Verbundscheibe mit einem zweiten Substrat und einer thermoplastischen Zwischenschicht,
- Figur 4: ein weiteres Substrat nach Anwendung des erfindungsgemäßen Verfahrens laminiert als Verbundscheibe mit einem zweiten Substrat und einer thermoplastischen Zwischenschicht,
- Figur 5: ein Ausschnitt eines weiteren Substrats nach Anwendung des erfindungsgemäßen Verfahrens,
- Figuren 6, 7 und 8: eine schematische vergrößerte Darstellung jeweils eines Substrats vor Anwendung des erfindungsgemäßen Verfahrens (a) und nach Anwendung des erfindungsgemäßen Verfahrens (b),
- Figur 9: ein Flussdiagramm einer Ausführungsform des erfindungsgemäßen Verfahrens.

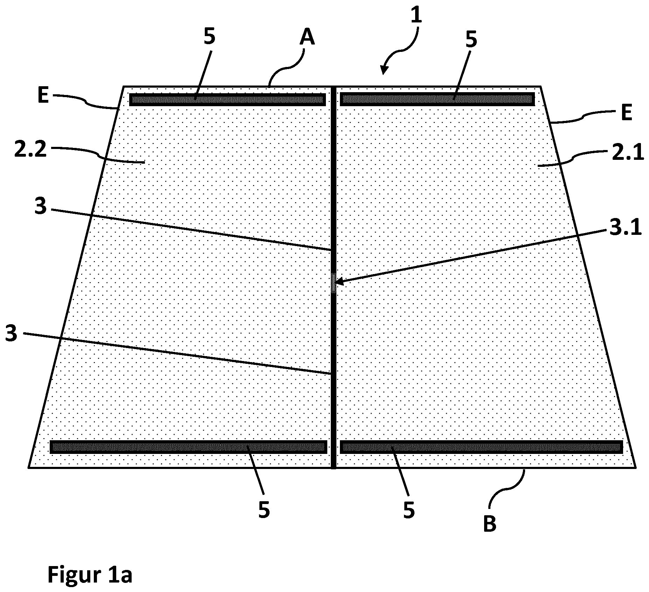

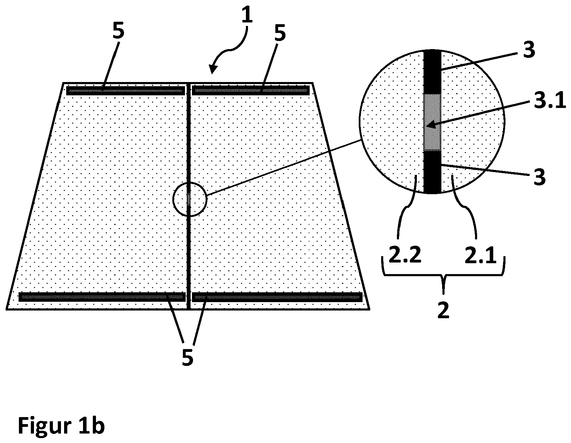

Figuren 1a und 1b zeigen ein Substrat (1) mit einer elektrisch leitfähigen Beschichtung (2), die von einer Isolationslinie (3) mit einer Breite von 100 µm in einen ersten Teilbereich (2.1) und einen zweiten Teilbereich (2.2) aufgeteilt wird, wobei die Isolationslinie (3) einen Defekt (3.1) aufweist. Die Isolationslinie (3) verläuft senkrecht zur Dachkante (A) bzw. zur Motorkante (B). Die Grundform des Substrats (1) entspricht einer Windschutzscheibe eines Personenkraftwagens. In jedem der Teilbereiche (2.1, 2.2) sind jeweils zwei Sammelleiter (5) aufgebracht. Jeweils ein Sammelleiter (5) pro Teilbereich (2.1, 2.2) verläuft parallel zur Dachkante (A) des Substrats (1), während ein Sammelleiter pro Teilbereich (2.1, 2.2) parallel zur Motorkante (B) des Substrats (1) aufgebracht ist. Die Sammelleiter (5) erstrecken sich jeweils ausschließlich innerhalb eines der Teilbereiche (2.1, 2.2). Mittels dieser Anordnung von Sammelleitern (5) und Isolationslinie (3) sollen zwei unabhängig voneinander schaltbare Heizfelder erzeugt werden, welche in dieser Form jedoch nicht funktionsfähig sind, da die Isolationslinie (3) über einen Defekt (3.1) verfügt. Figur 1b zeigt eine vergrößerte Darstellung des Defekts (3.1) der Isolationslinie (3). Im Bereich des Defekts (3.1) sind der erste Teilbereich (2.1) und der zweite Teilbereich (2.2) der Beschichtung (2) elektrisch leitend miteinander verbunden. Der Defekt (3.1) wird von elektrisch leitfähigen Partikeln, hervorgerufen, die eine elektrisch leitende Verbindung der Teilbereiche (2.1, 2.2) herstellen. Das Substrat (1) besteht aus Kalk-Natron-Glas mit einer Dicke von 1,6 mm. Die elektrisch leitfähige Beschichtung (2) umfasst drei leitfähige Silberschichten mit zwischen diesen angeordneten dielektrischen Schichten. Die elektrisch leitfähige Beschichtung (2) wurde mittels Magnetron-Sputtern auf dem Substrat (1) abgeschieden. Die Isolationslinie (3) wurde mittels Laserablation in die elektrisch leitfähige Beschichtung (2) eingebracht. Die Sammelleiter (5) sind als aufgedruckte leitfähige Struktur ausgebildet. Dazu wurde eine silberhaltige Siebdruckpaste aufgedruckt und eingebrannt. Da die Teilbereiche (2.1, 2.2) über den Defekt (3.1) elektrisch leitend verbunden sind, ist eine unabhängige Beheizung der Teilbereiche (2.1, 2.2) nicht möglich, da über den Defekt (3.1) ein Stromfluss erfolgt. Das Substrat (1) ist demnach ohne eine Behebung des Defekts (3.1) nicht verwertbar.

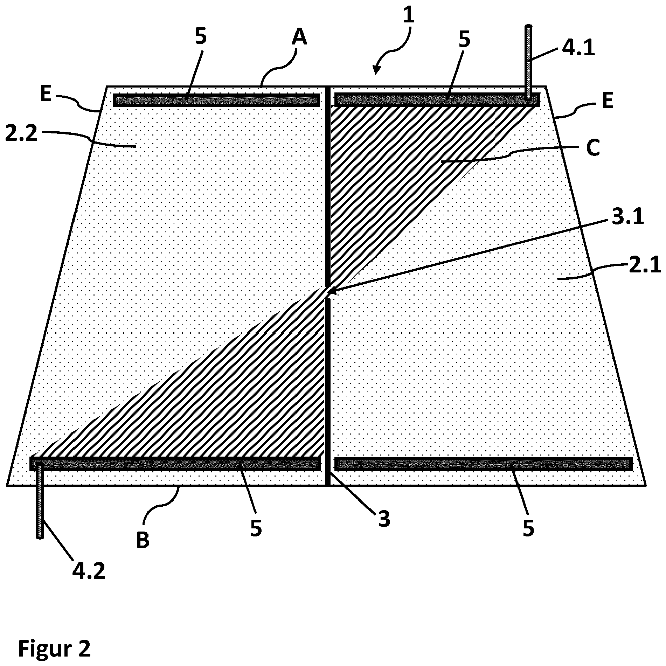

Figur 2 zeigt das Substrat gemäß Figuren 1a und 1b, wobei an jeweils einem Sammelleiter (5) jedes Teilbereichs (2.1, 2.2) ein elektrischer Kontakt (4.1, 4.2) elektrisch leitend kontaktiert ist. Im ersten Teilbereich (2.1) ist der erste elektrische Kontakt (4.1) auf dem benachbart zur Dachkante (A) befindlichen Sammelleiter (5) aufgelegt. Innerhalb dieses Sammelleiters (5) ist der erste elektrische Kontakt an dem der nächstliegenden Seitenkante (E) benachbarten Ende des Sammeleiters (5) positioniert. Der zweite elektrische Kontakt (4.2) ist diagonal gegenüber dem ersten elektrischen Kontakt (4.1) auf einem Sammelleiter (5) des zweiten Teilbereichs (2.2) angebracht. Der zweite elektrische Kontakt (4.2) ist dabei im zweiten Teilbereich (2.2) auf dem zur Motorkante (B) benachbarten Sammelleiter (5) aufgelegt. Auch in diesem Fall erfolgt die Positionierung an dem der nächstliegenden Seitenkante (E) benachbarten Ende des Sammelleiters (5). Bei Anlegen einer Spannung zwischen den elektrischen Kontakten (4.1, 4.2) fließt ein Strom über die beteiligten Sammelleiter (5) und die Beschichtung (2) zwischen erstem elektrischen Kontakt (4.1) und zweitem elektrischen Kontakt (4.2). Der Stromfluss zwischen den Teilbereichen (2.1, 2.2) erfolgt ausschließlich über den Defekt (3.1), da dieser die einzige elektrisch leitende Verbindung der Teilbereiche (2.1, 2.2) darstellt. Der Defekt (3.1) stellt somit den Bereich des Substrats (1) mit der höchsten Stromdichte dar. Der stromdurchflossene Bereich (C) ist gemäß Figur 2 als schraffierte Fläche skizziert. Die Durchführung des erfindungsgemäßen Verfahrens ist auch bei einer beliebigen Positionierung der elektrischen Kontakte (4.1, 4.2) möglich, solange beide Kontakte (4.1, 4.2) so in den unterschiedlichen Teilbereichen (2.1, 2.2) kontaktiert werden, dass bei Anlegen einer Spannung der Stromfluss über den Defekt (3.1) erfolgt. Eine Positionierung gemäß Figur 2 ist vorteilhaft wenn im bisherigen Produktionsprozess bereits eine Messstation zur Widerstandsmessung und Qualitätskontrolle vorliegt, die über entsprechende positionierte Kontakte verfügt.

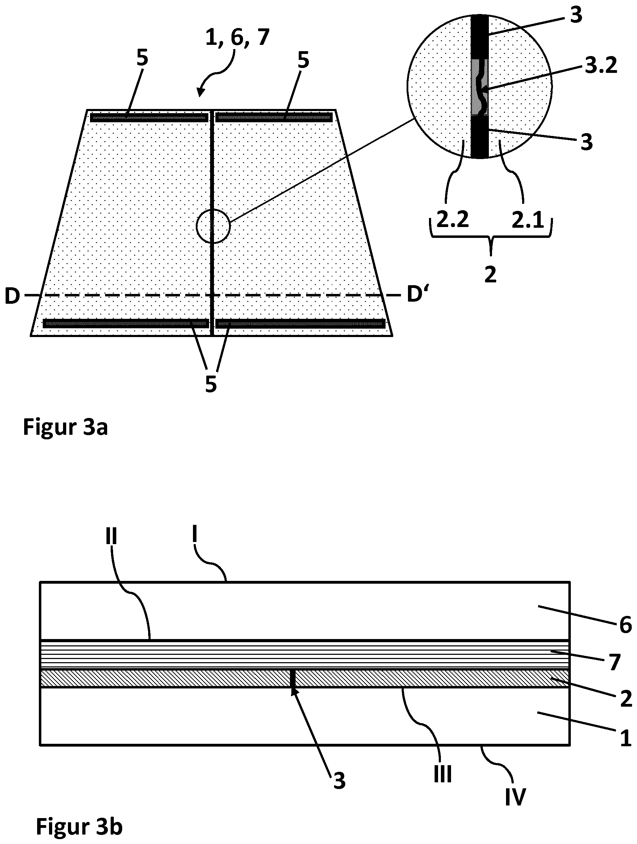

Figuren 3a und 3b zeigen das Substrat (1) gemäß Figuren 1a und 1b nach Ausführung des erfindungsgemäßen Verfahrens laminiert als Verbundscheibe mit einem zweiten Substrat (6) und einer thermoplastischen Zwischenschicht (7). Dabei wurden an dem Substrat (1) gemäß Figuren 1a und 1b zunächst ein erster elektrischer Kontakt (4.1) und ein zweiter elektrischer Kontakt (4.2) angelegt, wobei die Anordnung dem in Figur 2 gezeigten Aufbau entsprach. Zwischen dem ersten elektrischen Kontakt (4.1) und dem zweiten elektrischen Kontakt (4.2) wurde für 5 Sekunden eine Spannung von 14 V angelegt. Die hohe Stromdichte im Bereich des Defekts (3.1) führt zu einer sehr starken lokalen Erwärmung in diesem Bereich, wodurch ein Bereich mit thermisch zersetzter Beschichtung entsteht, der zwischen den Enden der Isolationslinie (3) verläuft und so die Isolationslinie (3) vervollständigt. Im Bereich des dadurch erzeugten reparierten Defekts (3.2) fließt kein Strom mehr zwischen den Teilbereichen (2.1, 2.2). Der reparierte Defekt (3.2) ist bei entsprechender optischer Vergrößerung als solcher erkennbar, allerdings im alltäglichen Gebrauch der Scheibe für den Betrachter nicht erkennbar und optisch unauffällig. Bezüglich des Heizverhaltens ist das Substrat (1) mit repariertem Defekt (3.2) nicht von Substraten unterscheidbar, deren Isolationslinie nie über einen Defekt verfügte. Das nach dem erfindungsgemäßen Verfahren behandelte Substrat (1) ist gemäß Figuren 3a und 3b über eine thermoplastische Zwischenschicht (7) mit einem zweiten Substrat (6) zu einer Windschutzscheibe laminiert, wobei Figur 3a eine Draufsicht und Figur 3b einen Querschnitt dieser Anordnung entlang der Schnittlinie D-D' zeigt. Das Substrat (1) mit repariertem Defekt (3.2) der Isolationslinie (3) stellt dabei die Innenscheibe der Windschutzscheibe dar, wobei die Außenseite (IV) des Substrats (1) in Einbaulage der Windschutzscheibe zum Fahrzeuginnenraum gerichtet ist und auf der Innenseite (III) des Substrats (1) die elektrisch leitfähige Beschichtung (2) aufgebracht ist. Auf der elektrisch leitfähigen Beschichtung (2) liegt die thermoplastische Zwischenschicht (7) auf. Die thermoplastische Zwischenschicht (7) besteht aus einer Polyvinylbutyral-Folie mit einer Dicke von 0,76 mm. Auf der gegenüberliegenden Oberfläche der thermoplastischen Zwischenschicht (7) befindet sich die Innenseite (II) des zweiten Substrats (6). Das zweite Substrat (6) besteht aus Kalk-Natron-Glas mit einer Dicke von 2,1 mm. Das zweite Substrat (6) stellt die Außenscheibe der Windschutzscheibe dar, wobei die Außenseite (I) des zweiten Substrats (6) in Einbaulage in Richtung der äußeren Umgebung zeigt.

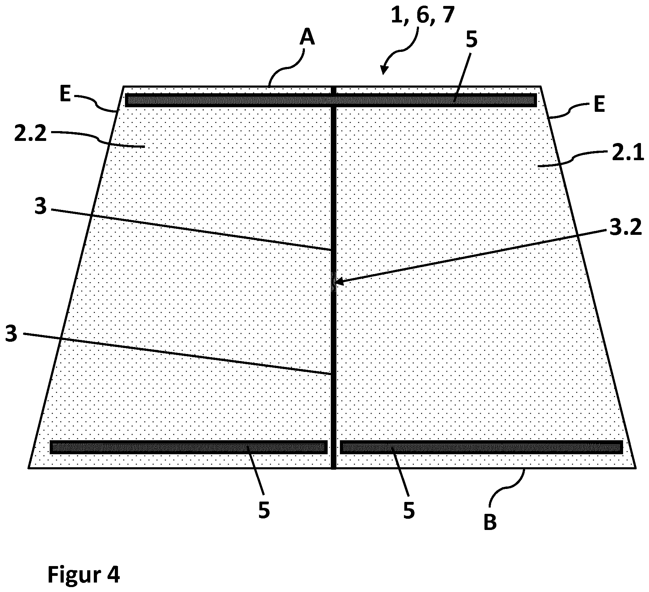

Figur 4 zeigt ein weiteres Substrat (1) nach Anwendung des erfindungsgemäßen Verfahrens, Anbringen von Sammelleitern (5) und Lamination mit einer thermoplastischen Zwischenschicht (7) und einem zweiten Substrat (6). Der Aufbau sowie die verwendeten Verfahrensparameter entsprechen im Wesentlichen den in Figur 3a und 3b beschriebenen. Im Unterschied dazu befindet sich benachbart zur Dachkante (A) ein einziger Sammelleiter (5), der den ersten Teilbereich (2.1) und den zweiten Teilbereich (2.2) elektrisch leitend verbindet. Eine derartige Konfiguration von Sammelleitern (5) und Isolationslinie wird beispielsweise bei Windschutzscheiben gewählt, die mit einer Spannung von 42 V oder 48 V betrieben werden sollen. Besonders Elektrofahrzeuge verfügen über diese, im Vergleich zur üblichen Bordspannung von 14 V, hohen Bordspannungen. Ein Scheibendesign gemäß Figuren 3a und 3b ist auf eine solche Bordspannung von 14 V ausgelegt, wobei höhere Spannungen zu einer unerwünscht hohen Heizleistung führen würden. Die Konfiguration gemäß Figur 4 führt dazu, dass die beiden Teilbereiche (2.1, 2.2) als in Reihe geschaltete Heizfelder fungieren, was zu einer Reduzierung der Heizleistung auf das gewünschte Maß führt. Das erfindungsgemäße Verfahren wird bei einer Sammelleiterkonfiguration gemäß Figur 4 vor dem Aufbringen der Sammelleiter (5) angewendet. Dies ist erforderlich, da andernfalls ein Teil des Stromflusses über den der Dachkante (A) benachbarten Sammelleiter (5) erfolgt und nicht über den Defekt. Nach Reparatur des Defektes werden die Sammelleiter (5) aufgebracht und das Substrat (1) analog zu der in Figuren 3a und 3b gezeigten Anordnung laminiert, wodurch sich die Verbundscheibe gemäß Figur 4 ergibt.

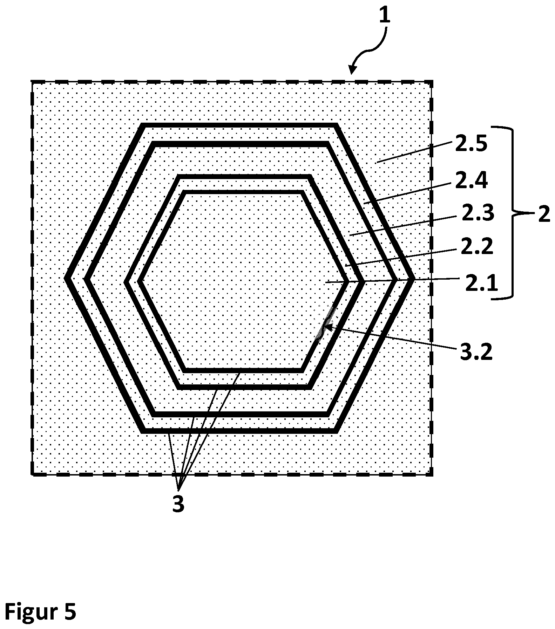

Figur 5 zeigt ein Ausschnitt eines weiteren Substrats (1) nach Anwendung des erfindungsgemäßen Verfahrens. Im Wesentlichen entspricht das Substrat (1) dem in Figuren 1a und 1b beschriebenen. In die Beschichtung sind verschiedene konzentrisch zueinander befindliche Isolationslinien (3) mit einer Breite von 35 µm eingebracht, die die Beschichtung in Teilbereiche (2.1, 2.2, 2.3, 2.4, 2.5) unterteilen. Die zwischen dem ersten Teilbereich (2.1) und dem zweiten Teilbereich (2.2) verlaufende Isolationslinie (3) verfügt über einen reparierten Defekt (3.2). Zur Reparatur des Defekts wurde das erfindungsgemäße Verfahren angewandt, wobei der erste elektrische Kontakt an einer beliebigen Position innerhalb des ersten Teilbereichs (2.1) und der zweite elektrische Kontakt an einer beliebigen Position innerhalb des zweiten Teilbereichs (2.2) positioniert und eine Spannung von 10 V für 3 Sekunden angelegt wurde.

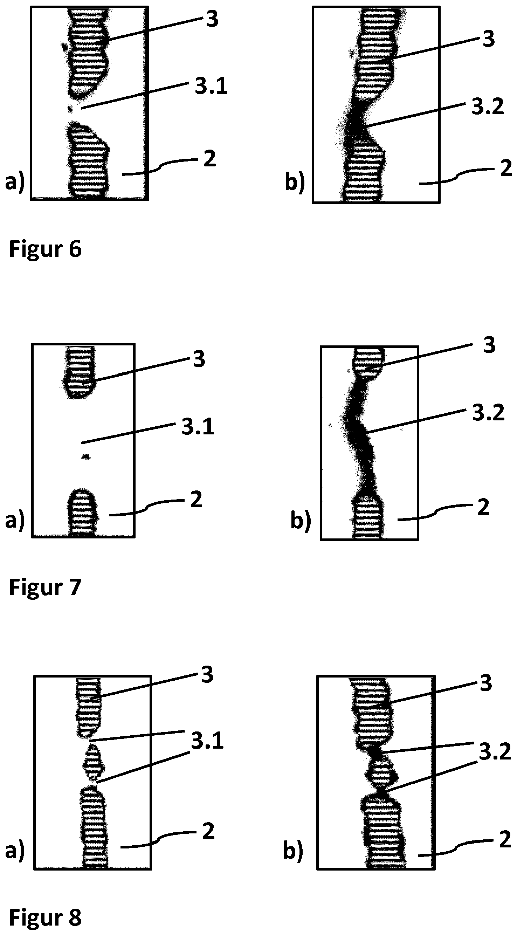

Figuren 6, 7 und 8 zeigen jeweils eine schematische vergrößerte Darstellung eines Substrats (1) vor Anwendung des erfindungsgemäßen Verfahrens (a) und nach Anwendung des erfindungsgemäßen Verfahrens (b). Das Substrat (1) entsprach dabei in allen Fällen dem in Figuren 1a und 1b gezeigten. Zwischen den gemäß Figur 2 angelegten elektrischen Kontakten (4.1, 4.2) wurde eine Spannung von 20 V für 3 Sekunden angelegt. Es wurde eine Versuchsreihe mit 1000 Substraten durchgeführt, bei denen vor Durchführung des erfindungsgemäßen Verfahrens 30 % der Substrate über einen Defekt (3.1) der Isolationslinie (3) verfügten. Nach Durchführung des erfindungsgemäßen Verfahrens konnte der Anteil an Substraten mit Defekten auf 0 % reduziert werden. Alle Defekte (3.1) der Isolationslinie (3) konnten durch Einsatz des erfindungsgemäßen Verfahrens beseitigt werden. Stichprobenartig wurden einige Substrate (1), die vorher über einen Defekt (3.1) verfügten, entnommen und vor bzw. nach Einsatz des erfindungsgemäßen Verfahrens untersucht. Figuren 6, 7 und 8 zeigen eine vergrößerte Darstellung der Umgebung des Defekts (3.1) vor Anwendung des Verfahrens (siehe Figuren 6a, 7a und 8a) und nach Anwendung des Verfahrens (siehe Figuren 6b, 7b, 8b). Die mittels Laserablation erzeugte Isolationslinie (3) ist als schraffierte Fläche in der Beschichtung (2) dargestellt. In diesem Bereich ist die Beschichtung (2) entfernt. Nach Anwendung des erfindungsgemäßen Verfahrens sind die dem Defekt (3.1) benachbarten Enden der Isolationslinie (3) durch einen Bereich mit thermisch zersetzter Beschichtung innerhalb der Beschichtung (2) verbunden. Im Bereich dieser thermisch zersetzten Beschichtung liegen keine leitfähigen Komponenten mehr vor. Über den entstehenden reparierten Defekt (3.2) hinweg findet somit kein Stromfluss mehr statt.

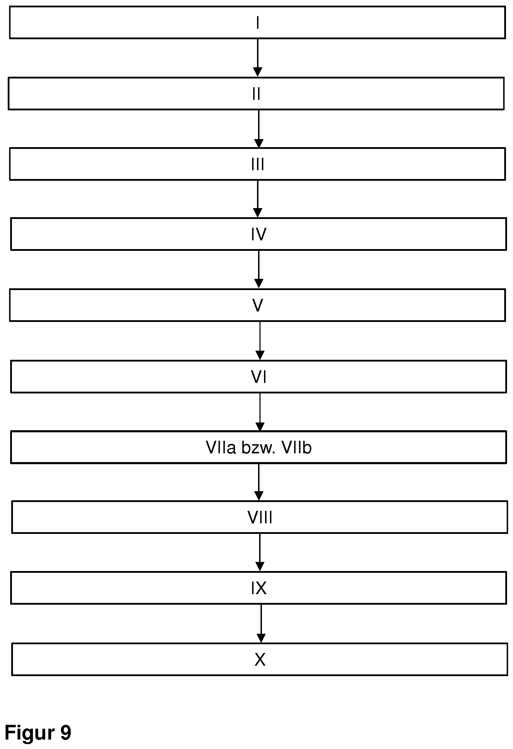

Figur 9 zeigt ein Flussdiagramm einer Ausführungsform des erfindungsgemäßen Verfahrens zur Herstellung der in Figuren 3a und 3b beschriebenen Verbundscheibe. Die in Figur 9 gezeigten Verfahrensschritte lauten wie folgt:
I Abscheiden einer elektrisch leitfähigen Beschichtung (2) auf der Innenseite (III) eines Substrats (1)
II Einbringen der Isolationslinie (3) in die elektrisch leitfähige Beschichtung (2) mittels Laserablation
III Aufbringen der Sammelleiter (5) mittels Siebdruck
IV Kontaktieren eines ersten elektrischen Kontakts (4.1) mit dem ersten Teilbereich (2.1) und Kontaktieren eines zweiten elektrischen Kontakts (4.2) mit dem zweiten Teilbereich (2.2) der elektrisch leitfähigen Beschichtung (2)
V Anlegen einer Spannung Uₙ zwischen erstem elektrischen Kontakt (4.1) und zweitem elektrischen Kontakt (4.2)
VI Messen ob ein elektrischer Strom zwischen erstem Teilbereich (2.1) und zweitem Teilbereich (2.2) fließt
Vlla sofern ein Strom zwischen erstem Teilbereich (2.1) und zweitem Teilbereich (2.2) fließt: Wiederholung der Schritte V und VI mit einer Spannung Uₙ₊₁, wobei Uₙ₊₁ größer als Uₙ ist
Vllb sofern kein Strom zwischen erstem Teilbereich (2.1) und zweitem Teilbereich (2.2) fließt: Fortführen des Verfahrens mit Schritt VIII
VIII Auflegen einer thermoplastischen Zwischenschicht (7) auf der elektrisch leitfähigen Beschichtung (2) des Substrats (1)
IX Auflegen eines zweiten Substrats (6) auf die thermoplastische Zwischenschicht (7), wobei die Innenseite (II) des zweiten Substrats (6) in Richtung der thermoplastischen Zwischenschicht (7) zeigt
X Laminieren des Schichtstapels zu einer Verbundscheibe

Die Reihenfolge der Schritte II und II ist beliebig. Schritt III kann alternativ auch zwischen Schritt Vllb und Schritt VIII erfolgen.

### Bezugszeichenliste:

- (1): Substrat
- (2): elektrisch leitfähige Beschichtung
- (2.1): erster Teilbereich der elektrisch leitfähigen Beschichtung
- (2.2): zweiter Teilbereich der elektrisch leitfähigen Beschichtung
- (2.n): n-ter Teilbereich der elektrisch leitfähigen Beschichtung, wobei n eine ganze Zahl > 1 ist
- (3): Isolationslinie
- (3.1): Defekt der Isolationslinie
- (3.2): reparierter Defekt
- (4): elektrische Kontakte
- (4.1): erster elektrischer Kontakt
- (4.2): zweiter elektrischer Kontakt
- (5): Sammelleiter
- (6): zweites Substrat
- (7): thermoplastische Zwischenschicht

- (A): Dachkante
- (B): Motorkante
- (C): stromdurchflossener Bereich
- D-D': Schnittlinie
- (E): Seitenkanten

- (I): Außenseite des zweiten Substrats
- (II): Innenseite des zweiten Substrats
- (III): Innenseite des Substrats
- (IV): Außenseite des Substrats

## Patentansprüche

1. Verfahren zur Nachbehandlung eines Substrats (1) mit einer elektrisch leitfähigen Beschichtung (2) und mindestens einer Isolationslinie (3) im Produktionsprozess, wobei
a) ein Substrat (1) bereitgestellt wird mit:
- einer elektrisch leitfähigen Beschichtung (2) auf mindestens einer Oberfläche des Substrats (1),
- mindestens einer Isolationslinie (3) in der elektrisch leitfähigen Beschichtung (2),
- mindestens einem ersten Teilbereich (2.1) und einem zweiten Teilbereich (2.2) der Beschichtung (2), zwischen denen die Isolationslinie (3) verläuft,
- mindestens einem Defekt (3.1) der Isolationslinie (3), in dessen Bereich der lokale Schichtwiderstand geringer ist als der Schichtwiderstand der Isolationslinie (3) außerhalb des Defekts (3.1)
b) ein erster elektrischer Kontakt (4.1) mit dem ersten Teilbereich (2.1) und ein zweiter elektrischer Kontakt (4.2) mit dem zweiten Teilbereich (2.2) der elektrisch leitfähigen Beschichtung (2) elektrisch leitend verbunden werden,
c) eine Spannung Uₙ zwischen erstem elektrischen Kontakt (4.1) und zweitem elektrischen Kontakt (4.2) angelegt wird,
d) mittels des ersten elektrischen Kontakts (4.1) und des zweiten elektrischen Kontakts (4.2) gemessen wird ob ein elektrischer Strom zwischen erstem Teilbereich (2.1) und zweitem Teilbereich (2.2) fließt,
e) sofern ein Strom zwischen erstem Teilbereich (2.1) und zweitem Teilbereich (2.2) fließt, die Schritte c) und d) mit einer Spannung von größer oder gleich Uₙ wiederholt werden, bis in Schritt d) kein Strom mehr zwischen erstem Teilbereich (2.1) und zweitem Teilbereich (2.2) gemessen werden kann,
wobei der flächenmäßige Anteil des Defekts (3.1) an der Gesamtfläche der Isolationslinie (3) kleiner als 10 % ist, wobei der Strom zu einer thermischen Zersetzung der elektrisch leitfähigen Beschichtung im Bereich des Defekts (3.1) führt.

2. Verfahren nach Anspruch 1, wobei in Schritt e) eine Spannung von Uₙ₊₁ angelegt wird mit Uₙ₊₁ > Uₙ und wobei die Spannung bevorzugt bei jeder Wiederholung iterativ erhöht wird.

3. Verfahren nach einem der Ansprüche 1 oder 2, wobei die Spannungen Uₙ und Uₙ₊₁ kleiner als 200 V, bevorzugt zwischen 3 V und 50 V betragen.

4. Verfahren nach Anspruch 3, wobei die Spannung in Schritt c) für 1 Sekunde bis 10 Sekunden, bevorzugt 2 Sekunden bis 6 Sekunden, angelegt wird.

5. Verfahren nach einem der Ansprüche 1 bis 4, wobei der erste elektrische Kontakt (4.1) und der zweite elektrische Kontakt (4.2) unmittelbar die elektrisch leitfähige Beschichtung (2) im ersten Teilbereich (2.1) und zweiten Teilbereich (2.2) kontaktieren.

6. Verfahren nach einem der Ansprüche 1 bis 4, wobei vor Schritt b) mindestens ein Sammelleiter (5) im ersten Teilbereich (2.1) und/oder zweiten Teilbereich (2.2) elektrisch leitend auf die elektrisch leitfähige Beschichtung (2) aufgebracht wird und die Sammelleiter (5) keinen elektrischen Kontakt zwischen dem ersten Teilbereich (2.1) und dem zweiten Teilbereich (2.2) herstellen.

7. Verfahren nach Anspruch 6, wobei der erste elektrische Kontakt (4.1) und der zweite elektrische Kontakt (4.2) in Schritt b) an den Sammelleitern (5) kontaktiert werden.

8. Verfahren nach einem der Ansprüche 1 bis 7, wobei das Substrat (1) nach Schritt e) unter Zwischenlage einer thermoplastischen Zwischenschicht (7) mit mindestens einem zweiten Substrat (6) zu einer Verbundscheibe laminiert wird.

9. Verwendung eines Verfahrens nach einem der Ansprüche 1 bis 8 zur Reparatur von Isolationslinien (3) in leitfähigen Beschichtungen (2) in Automobilverglasung, bevorzugt Windschutzscheiben, Seitenscheiben oder Heckscheiben.

## Claims

1. Method for post-treating a substrate (1) having an electrically conductive coating (2) and at least one isolating line (3) in the production process, wherein
a) a substrate (1) is provided having:
- an electrically conductive coating (2) on at least one surface of the substrate (1),
- at least one isolating line (3) in the electrically conductive coating (2),
- at least one first subregion (2.1) and one second subregion (2.2) of the coating (2), between which the isolating line (3) runs,
- at least one defect (3.1) of the isolating line (3), in the region of which the local sheet resistance is lower than the sheet resistance of the isolating line (3) outside the defect (3.1)
b) a first electric contact (4.1) is electrically conductingly connected to the first subregion (2.1) and a second electric contact (4.2) is electrically conductingly connected to the second subregion (2.2) of the electrically conductive coating (2),
c) a voltage Uₙ is applied between the first electric contact (4.1) and the second electric contact (4.2),
d) a measurement is taken using the first electric contact (4.1) and the second electric contact (4.2) whether an electric current is flowing between the first subregion (2.1) and the second subregion (2.2),
e) if a current is flowing between the first subregion (2.1) and the second subregion (2.2), the steps c) and d) are repeated with a voltage greater than or equal to Uₙ, until, in step d), a current can no longer be measured between the first subregion (2.1) and the second subregion (2.2), wherein the areal proportion of the defect (3.1) to the total surface area of the isolating line (3) is less than 10%, wherein the electric current causes a thermal decomposition of the electrically conductive coating (2) in the region of the defect (3.1).

2. Method according to claim 1, wherein in step e) a voltage of Uₙ₊₁ is applied, with Uₙ₊₁ > Uₙ und wherein the voltage is preferably increased iteratively with each repetition.

3. Method according to one of claims 1 or 2, wherein the voltages Uₙ and Uₙ₊₁ are less than 200 V, preferably between 3 V and 50 V.

4. Method according to claim 3, wherein the voltage in step c) is applied for 1 second to 10 seconds, preferably 2 seconds to 6 seconds.

5. Method according to one of claims 1 through 4, wherein the first electric contact (4.1) and the second electric contact (4.2) directly contact the electrically conductive coating (2) in the first subregion (2.1) and the second subregion (2.2).

6. Method according to one of claims 1 through 4, wherein prior to step b), at least one busbar (5) is electrically conductingly applied on the electrically conductive coating (2) in the first subregion (2.1) and/or the second subregion (2.2) and the busbars (5) produce no electric contact between the first subregion (2.1) and the second subregion (2.2).

7. Method according to claim 6, wherein the first electric contact (4.1) and the second electric contact (4.2) are contacted to the busbars (5) in step b).

8. Method according to one of claims 1 through 7, wherein after step e), the substrate (1) is laminated, with the interposition of a thermoplastic intermediate layer (7), to at least one second substrate (6) to form a composite pane.

9. Use of a method according to one of claims 1 through 8 for repairing isolating lines (3) in conductive coatings (2) in automobile glazing, preferably windshields, side windows, or rear windows.

## Revendications

1. Procédé de post-traitement d'un substrat (1) ayant un revêtement électriquement conducteur (2) et au moins une ligne d'isolation (3) dans le processus de production, dans lequel
a) un substrat (1) est fourni avec :
- un revêtement électriquement conducteur (2) sur au moins une surface du substrat (1),
- au moins une ligne d'isolation (3) dans le revêtement électriquement conducteur (2),
- au moins une première sous-région (2.1) et une deuxième sous-région (2.2) du revêtement (2), entre lesquelles passe la ligne de séparation (3),
- au moins un défaut (3.1) de la ligne de séparation (3), dans la zone duquel la résistance de feuille locale est inférieure à la résistance de feuille de la ligne de séparation (3) à l'extérieur du défaut (3.1)
b) un premier contact électrique (4.1) est relié de manière électriquement conductrice à la première sous-région (2.1) et un second contact électrique (4.2) est relié de manière électriquement conductrice à la seconde sous-région (2.2) du revêtement électriquement conducteur (2),
c) une tension Uₙ est appliquée entre le premier contact électrique (4.1) et le second contact électrique (4.2),
d) on mesure à l'aide du premier contact électrique (4.1) et du deuxième contact électrique (4.2) si un courant électrique circule entre la première sous-région (2.1) et la deuxième sous-région (2.2),
e) si un courant circule entre la première sous-région (2.1) et la deuxième sous-région (2.2), les étapes c) et d) sont répétées avec une tension supérieure ou égale à Uₙ, jusqu'à ce que, à l'étape d), un courant ne puisse plus être mesuré entre la première sous-région (2.1) et la deuxième sous-région (2.2),
dans lequel la proportion surfacique du défaut (3.1) par rapport à la surface totale de la ligne de séparation (3) est inférieure à 10%, dans lequel le courant électrique provoque une décomposition thermique du revêtement électriquement conducteur (2) dans la région du défaut (3.1).

2. Procédé selon la revendication 1, dans lequel à l'étape e) une tension de Uₙ₊₁ est appliquée, avec Uₙ₊₁ > Uₙ et dans lequel la tension est de préférence augmentée de manière itérative à chaque répétition.

3. Procédé selon l'une des revendications 1 ou 2, dans lequel les tensions Uₙ et Uₙ₊₁ sont inférieures à 200 V, de préférence comprises entre 3 V et 50 V.

4. Procédé selon la revendication 3, dans lequel la tension de l'étape c) est appliquée pendant 1 seconde à 10 secondes, de préférence 2 secondes à 6 secondes.

5. Procédé selon l'une des revendications 1 à 4, dans lequel le premier contact électrique (4.1) et le deuxième contact électrique (4.2) entrent directement en contact avec le revêtement électriquement conducteur (2) dans la première sous-région (2.1) et la deuxième sous-région (2.2).

6. Procédé selon l'une des revendications 1 à 4, dans lequel, avant l'étape b), au moins une barre conductrice (5) est appliquée de manière électriquement conductrice sur le revêtement électriquement conducteur (2) dans la première sous-région (2.1) et/ou la deuxième sous-région (2.2) et les barres conductrices (5) ne produisent aucun contact électrique entre la première sous-région (2.1) et la deuxième sous-région (2.2).

7. Procédé selon la revendication 6, dans lequel le premier contact électrique (4.1) et le second contact électrique (4.2) sont en contact avec les barres omnibus (5) à l'étape b).

8. Procédé selon l'une des revendications 1 à 7, dans lequel après l'étape e), le substrat (1) est stratifié, avec interposition d'une couche intermédiaire thermoplastique (7), sur au moins un deuxième substrat (6) pour former un vitrage composite.

9. Utilisation d'un procédé selon l'une des revendications 1 à 8 pour réparer des lignes d'isolation (3) dans des revêtements conducteurs (2) dans des vitrages automobiles, de préférence des pare-brises, des vitres latérales ou des vitres arrière.
